# EUROPEAN PATENT APPLICATION

(11) **EP 0 603 928 A1**
(43) Date of publication of application: **29.06.1994**
(21) Application number: 93203416.8
(22) Date of filing: 06.12.1993
(51) Int. Cl.: H01L 21/60, H01L 21/58, H01L 23/24, H01L 23/29, H01L 23/36

(54) **Hybrid circuit**

(30) Priority: 21.12.1992 US 993549
(71) Applicant: DELCO ELECTRONICS CORPORATION, Kokomo Indiana 46902 (US)
(72) Inventor: Orem, James Catlin, McCordsville, Indiana 46055 (US); Myers, Bruce Alan, Kokomo, Indiana 46901 (US); Blanton, James Arthur, Kokomo, Indiana 46901 (US)
(74) Representative: Denton, Michael John

(57) **Abstract**

A low thermal resistance flip chip (14) includes a backplate/heat sink (10) underlying a ceramic substrate (16) . An adhesive joint (20) is formed between the ceramic substrate (16) and the backplate/heat sink (10). A hybrid circuit is formed on the ceramic substrate (16) and includes an integrated circuit flip chip (14) having a first set of bumps (22) for electrical connection between the integrated circuit and the flip chip (14). A second set of bumps (thermal bumps) (26) are provided for dissipating heat from the flip chip (14). The thermal bumps (26) are electrically isolated from the flip chip by a thin dielectric/passivation layer (24). A thermally conductive epoxy (28) fills the gap between the flip chip (14) and ceramic substrate (16). A thermal gel blob top (30) is provided on top of the flip chip (14) to provide improved heat dissipation in the lateral or x/y directions.

## Description

This invention relates to a device including a hybrid circuit comprising a flip chip.

A variety of semiconductor devices are known for dissipating heat from heat empowered generating components. One system for mounting power dissipating integrated circuits on ceramic substrates is known as a Power Tape-Pak. However, that system is relatively expensive and requires large circuit areas compared to flip chips. Typical flip chip integrated circuit packages have limited capability for dissipating heat, with many having thermal resistances greater than 100°C/watt.

The present invention seeks to provide an improved device.

According to an aspect of the present invention, there is provided a device comprising a heat sink and a hybrid circuit as specified in claim 1.

According to another aspect of the present invention, there is provided a device comprising a hybrid circuit as specified in claim 12.

The present invention can provide a low cost, low thermal resistance system for flip chips with improved heat dissipating capabilities.

Preferred embodiments include at least one, or all depending on the heat load, of the following elements for a low thermal resistance flip chip device. A backplate/heat sink, which may include a pedestal, is mounted underneath a ceramic substrate with an adhesive joint. The pedestal may be of the same material as the backplate or a different material. The pedestal may extend 0.13 mm (.005") above the plane of the backplate and is preferably centrally positioned just under where the flip chip will be mounted. The pedestal compensates for variations in flatness in both the ceramic substrate and the backplate allowing a thinner adhesive joint directly below the power dissipating flip chip, thereby reducing the resistance to heat flow in the adhesive layer, while maintaining a thicker adhesive joint over the rest of the backplate required for greater joint compliance.

The adhesive used between the ceramic substrate and the backplate/heat sink can constitute a major portion of the total structure's thermal resistance. Preferably, the adhesive is an elastomeric material sufficiently compliant to absorb the relative movement between the ceramic substrate and the backplate/heat sink during thermal cycling as a result of the different thermal expansion characteristics of the two materials.

A hybrid circuit is preferably formed on the ceramic substrate including a conductor, resistor, dielectric materials and an integrated circuit flip chip having a first set of bumps for electrical connection between electrically conductive leads of the hybrid circuit. The first set of electrical bumps, which may be solder bumps, extend through the passivation layer to provide electrical connection between the chip and the thick film circuit on the ceramic substrate. A second set of bumps (thermal bumps) for dissipating heat from the flip chip is also included. However, a thin dielectric/passivation layer over the flip chip is provided for electrical isolation of the thermal bumps from the underlying circuitry on the flip chip. The thermal bumps may invade the thin dielectric/passivation layer, but do not extend therethrough. The thermal bumps are preferably positioned in an area of the chip generating the greatest heat and requiring the greatest heat dissipation. The thermal bumps may be prepared from materials similar to the electrical bumps. The thermal and electrical bumps are preferably applied to the flip chip simultaneously. To avoid the addition of the thermal bumps to the flip chip causing the chip to be soldered down in a lopsided manner, larger solder pads 0.2 mm square (.008" square), consisting of a ceramic substrate conductor material, may be applied at those locations on the ceramic substrate to provide uniform solder bump joint height thus assuring that the chip is held substantially parallel to the underlying ceramic substrate.

A thermally conductive epoxy may be provided to fill the gap between the soldered down flip chip and the ceramic substrate, encompassing the bottom face and sides of the flip chip and all of the bumps to provide improved thermal conductivity and increased area for heat flow to the underlying ceramic substrate. Flip chip solder joint reliability during temperature cycling can be greatly improved by providing a rigid mechanical attachment of the epoxy between the chip and substrate reducing the stress on the flip chip bumps caused by differences in thermal expansion of the chip and substrate and by self-heating of localised areas of the flip chip.

A thermally conductive gel blob top is preferably provided on top of the flip chip for improved heat dissipation particularly in the lateral or x/y directions.

An embodiment of the present invention is described below, by way of example only, with reference to the accompanying drawing in which the sole Figure is a cross-sectional view of an embodiment of flip chip.

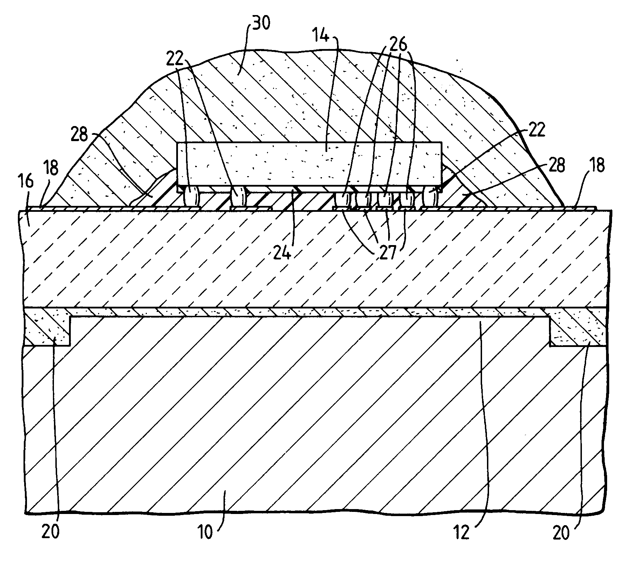

Figure 1 illustrates one embodiment of low thermal resistance flip chip system which includes a backplate/heat sink 10 and may include a pedestal 12. The pedestal 12 can provide a thinner adhesive joint between the substrate and backplate while retaining a thicker adhesive joint in other areas. The pedestal 12 is centrally located beneath the associated flip chip and is typically elevated 0.127 mm (.005") higher than the rest of the backplate and is typically two to ten times larger in surface area than the associated flip chip 14. A suitable material for the backplate/heat sink 10 may be any metal, preferably aluminium. Overlying the backplate/heat sink 10 is a ceramic substrate 16. Suitable ceramic substrates are known to those skilled in the art, and is preferably an alumina ceramic substrate. A hybrid circuit is formed on the substrate and may include a conductor 18, resistor, dielectric material and an integrated circuit flip chip 14. Interposed between the backplate/heat sink 10 and ceramic substrate is a thermal adhesive 20. The thermal adhesive is prepared from a resin comprising silicones and thermally conductive filler which may include alumina (Al₂O₃). A suitable thermal adhesive is available from Dow-Corning Company, under the product name 6843 or X3-6325.

The flip chip 14 includes a first set of bumps (electrical bumps) 22 extending through a passivation layer 24 on the chip to provide electrical connection between the flip chip 14 and electrically conductive leads 18 of the hybrid circuit formed on the ceramic substrate 16. The electrical bumps 22 may be bonded to a solder pad on the substrate 16 which is part of the conductive lead. A suitable material for the electrical bumps is a solder material comprising indium and lead, or tin and lead.

A second set of bumps (thermal bumps) 26 are provided on the passivation layer 24 at areas where the heat generation is greatest on the chip and where heat dissipation is required. The thermal bumps 26 may invade but do not extend through the passivation layer 24 on the flip chip. Thus, the thermal bumps 26 do not provide electrical connection between leads 18 of the hybrid circuit and the flip chip 14. The thermal bumps 26 may be bonded to solder pads 27 on the substrate. The thermal bumps 26 preferably have a thermal coefficient of expansion similar to the electrical bumps 22 and are preferably made out of the same material.

A thermally conductive epoxy 28 is applied by flowing the same along one or more edges of the flip chip 14. Capillary action causes the epoxy to flow under the chip causing it to fill completely the gap between the soldered down flip chip 14 and the ceramic substrate 16. The epoxy 28 extends up the sides and completely covers the bottom face of the flip chip 14 and all of the bumps 22, 26, providing improved thermal conductivity and increased area for heat flow to the underlying ceramic substrate 16. Reliability of the flip chip solder joint during temperature cycling is also greatly improved. The thermally conductive epoxy 28 is prepared from epoxy resins and thermally conductive filler. Preferably, the thermal epoxy includes up to 10 percent by weight of a cycloaliphatic epoxide, 10-25 percent by weight of methyl hexahydrophthalic anhydride, with the balance about 65 to 90 weight percent conductive filler, and/or a curable cyanate ester. The conductive filler includes Al₂O₃ particles. Preferably, the thermal epoxy has a thermal conductivity of at least 24x10⁻⁴ cal/cm sec °C. A suitable thermally conductive epoxy is available from Dexter Company, under the trade name HYSOL CNB582-24.

A blob top 30 of thermal gel is provided covering the flip chip 14 to provide improved thermal resistance and heat dissipation in the lateral, x/y directions (parallel to the longitudinal axis of the flip chip). The thermal gel may comprise silicones and thermally conductive filler. The conductive filler may include aluminium nitride and silicon particles each in about 30 percent weight of the composition. A suitable thermal gel is available from Dow-Corning Company, under the trade name X3-6844. Preferably the blob top thermal gel has a thermal conductivity of at least 2.0 W/mK. Typically, the thermal gel is applied to the top of the flip chip in a thickness ranging from about 0.25 mm (.010") to about 2.5 mm (0.1"), and most preferably about 1.3 mm (.050") and may extend beyond the flip chip's perimeter.

Standard integrated circuit packages have limited capability to dissipate heat. Many of these packages have thermal resistances of greater than 100°C/watt. Some plastics-packaged flip chip systems have a thermal resistance of about 60°C/watt or more. However, the packaging system of this embodiment provides a surprising improvement in thermal resistance. A hybrid circuit was prepared using a fully functional flip chip including calibrated thermal shutdown circuits. The flip chip was packaged as illustrated in Figure 1 including an aluminium backplate with pedestal, thermal bumps, epoxy filled gap and thermal gel blob top. Power was applied to the circuit and the thermal shutdown circuit was monitored to determine thermal resistance. The system was found to have 4.5-6.0°C/watt thermal resistance values.

The following examples also illustrate selective features, advantages and results of the described embodiments.

### EXAMPLE 1

In this example, a standard test flip chip was prepared having resistors and thermal diodes. The resistors were used to generate heat on the chip and the thermal diodes recorded temperature changes. The standard test flip chip was mounted on an alumina ceramic hybrid circuit with a silicone gel, SYLGARD from Dow Corning Corporation, under the chip. The ceramic substrate was mounted on aluminium backplate/heat sink without a pedestal. None of the features of the described embodiments were incorporated in this structure. The structure had a thermal resistance of 50°C/watt.

### EXAMPLE 2

The same test chip as described in Example 1 was utilised with the following differences. Twenty-one electrical bumps were positioned around the periphery of the test chip and connected to a hybrid circuit on the ceramic substrate, thermal adhesive, Dow-Corning 6843, was applied to the flat backplate heat sink. SYLGARD was also underneath the chip. This device had a thermal resistance of 20°C/watt.

### EXAMPLE 3

A device as disclosed in Example 2 was prepared with the following differences. Four thermal bumps were placed near the centre of the chip. This device had a thermal resistance of 13°C/watt.

### EXAMPLE 4

In this example, a fully functional flip chip (as opposed to a test chip as in Examples 1-3) was prepared with eleven electrically active solder bumps around the periphery of the chip and thirty-two thermal bumps located in a high-power concentration area of the chip. SYLGARD was placed underneath the chip and Dow-Corning 6843 adhesive was applied to a pedestal backplate/heat sink as described above. This device had a thermal resistance of 13°C/watt.

### EXAMPLE 5

A device as described in Example 4 was prepared with the following differences. HYSOL epoxy CNB 582-24 was placed under the chip instead of SYLGARD. This device had a thermal resistance of 7.4°C/watt.

### EXAMPLE 6

A device as described in Example 5 was prepared with the following differences. A blob top of Dow-Corning 6844 thermal gel was placed on top of the flip chip. This device had a thermal resistance of 6.4°C/watt.

### EXAMPLE 7

A device was prepared as described in Example 5 with the following differences. Dow-Corning 6843 adhesive was replaced with Dow-Corning 6325 adhesive on the pedestal back/plate. No blob top was utilised. This device had a thermal resistance of 6.9°C/watt.

### EXAMPLE 8

A device as described in Example 7 was prepared with the following differences. A blob top of Dow-Corning 6844 thermal gel was placed over the flip chip. This device had a thermal resistance of 5.3°C/watt.

Table I summarises the thermal resistance (or improved heat dissipation) achieved in each of the above examples.

**TABLE I**

| | Thermal Resistance (°C/Watt) |
|---|---|
| Example 1 | 50 |
| Example 2 | 20 |
| Example 3 | 13 |
| Example 4 | 13 |
| Example 5 | 7.4 |
| Example 6 | 6.4 |
| Example 7 | 6.9 |
| Example 8 | 5.3 |

The disclosures in United States patent application no. 993,549, from which this application claims priority, and in the abstract accompanying this application are incorporated herein by reference.

## Claims

1. A device comprising a heat sink (10) and a hybrid circuit overlying the sink, the hybrid circuit including an integrated circuit flip chip (14) comprising a passivation layer (24) formed on a surface thereof closest to the heat sink; electrical solder bumps (22) extending through the passivation layer for providing electrical connection between the integrated circuit of the flip chip and leads (18) of the hybrid circuit; and thermal solder bumps (26) secured and extending up to the passivation layer, at areas of the flip chip to be heat dissipated, the thermal solder bumps providing substantially no electrical connection between the integrated circuit flip chip and the leads of the hybrid circuit.

2. A device according to claim 1, comprising a substrate (16) disposed between the heat sink and the hybrid circuit.

3. A device according to claim 2, comprising a thermal adhesive layer (20) between the substrate and the heat sink.

4. A device according to claim 3, wherein the adhesive includes thermally conductive particles embedded therein.

5. A device according to any preceding claim, comprising a thermal gel top (30) covering the flip chip.

6. A device according to claim 5, wherein the thermal top comprises a silicone gel composition including aluminium nitride and silicon particles.

7. A device according to any preceding claim, wherein the thermal solder bumps and/or the electrical solder bumps comprise lead and at least one material selected from the group consisting of indium and tin.

8. A device according to any preceding claim, wherein the heat sink includes a pedestal (12) underlying the flip chip, the pedestal having a width substantially greater than the width of the flip chip.

9. A device according to claim 8, wherein the pedestal has a width ranging from substantially two to ten times the width of the flip chip.

10. A device according to any preceding claim, comprising a thermally conductive filler (28) substantially completely filling the gap between the surface of the flip chip closest to the substrate or heat sink and the substrate or heat sink, comprising an epoxy resin and substantially 65 to 90 percent by weight of a conductive filler comprising alumina particles.

11. A device according to claim 10, wherein the filler comprises substantially 20 to 25 percent by weight of methyl hexahydrophthalic anhydride; the epoxy resin including a cycloaliphatic epoxide.

12. A device comprising a hybrid circuit including an integrated circuit flip chip (14) comprising a thermal gel blob (30) comprising a silicone composition including aluminium nitride and silicon particles covering the flip chip to provide improved heat dissipation in a lateral direction relative to the hybrid circuit.
